# DEMANDE DE BREVET EUROPEEN

(11) **EP 2 520 415 A1**
(43) Date de publication de la demande: **07.11.2012**
(21) Numéro de dépôt: 12164464.5
(22) Date de dépôt: 17.04.2012
(51) Int. Cl.: B29C 63/02, H01L 21/683, H01L 23/00, B25B 11/00

(54) **Support de composants par dépression d'air et machine pour l'assemblage de composants correspondante**

(30) Priorité: 03.05.2011 FR 1153768
(71) Demandeur: S.E.T., 74490 St Jeoire (FR)
(72) Inventeur: Cavazza, Gilbert, 74250 VIUZ EN SALLAZ (FR)
(74) Mandataire: Gevers France

(57) **Abrégé**

Selon l'invention, le support (1) est formé d'un plateau de réception (2) comprenant une face plate de réception (3), une rainure d'aspiration (4) ménagée dans la face (3), formant une chambre d'aspiration (C) oblongue à parois longitudinales lisses, et un canal d'aspiration (5) pratiqué dans l'épaisseur du plateau (2) qui est apte à être relié, par une de ses deux extrémités (5A), à des moyens d'aspiration et qui s'arrête, par son autre extrémité (5B), dans le fond (6) de la rainure (4), de manière à pouvoir mettre en communication la chambre d'aspiration avec lesdits moyens d'aspiration (7).

## Description

La présente invention concerne un support de composants par dépression d'air, ainsi qu'une machine pour l'assemblage de composants correspondante.

On connaît déjà des machines pour l'assemblage de composants électroniques qui comprennent deux supports de composants, disposés en regard l'un de l'autre et aptes à être déplacés, de façon relative, transversalement l'un par rapport à l'autre pour pouvoir se rapprocher et s'éloigner.

Les premier et second supports portent respectivement un premier composant (par exemple une puce) et un second composant (par exemple un substrat), qui sont alignés précisément l'un par rapport à l'autre, généralement à l'aide d'un microscope, et amenés au contact l'un de l'autre par rapprochement desdits premier et second supports.

Lors de ce rapprochement, des billes de soudure (encore désignées « bumps » en anglais), régulièrement réparties sur une surface du premier composant, sont mises en contact avec des plots métalliques correspondants, disposés sur une surface du second composant. Un chauffage et une compression desdits composants l'un contre l'autre - étapes communément désignées par le terme « hybridation » - parachèvent leur assemblage.

Le maintien d'un composant contre le support correspondant - formé d'un plateau de réception présentant une face plate de réception destinée à recevoir le composant - est fréquemment assuré, de façon connue, par aspiration d'air au niveau d'une ou plusieurs rainures d'aspiration ménagées dans la face plate de réception du plateau. Ces rainures d'aspiration d'air, intégralement ou partiellement recouvertes par le composant, sont reliées, par un ou plusieurs canaux d'aspiration correspondants, à des moyens d'aspiration d'air qui créent une dépression d'air (ou vide) plaquant le composant contre la face plate de réception.

Les canaux d'aspiration, de forme cylindrique et diamètre supérieur à la largeur des rainures correspondantes, sont pratiqués dans l'épaisseur du plateau de réception et s'étendent sur au moins une partie de celui-ci, en traversant lesdites rainures correspondantes, selon une direction associée à leur profondeur, pour déboucher dans ladite face plate de réception en l'affleurant.

De par la dureté du matériau (par exemple du carbure de silicium) formant le plateau de réception et du fait que la force de maintien par dépression dépende de la surface d'aspiration formée par l'ensemble des rainures d'aspiration, il est courant de ne réaliser qu'un faible nombre de rainures d'aspiration dans la face de réception, qui présentent chacune une surface d'aspiration importante, afin de faciliter leur usinage et celui des canaux d'aspiration dans le plateau de réception.

Cependant, un composant mince d'épaisseur inférieure à 50 µm (par exemple égale à 20 µm) déposé sur un tel support de réception a tendance à se déformer sous l'action de la dépression d'air siégeant au niveau des rainures d'aspiration du support, sous la face du composant reposant contre le support de réception et/ou par la pression exercée, lors de l'hybridation, sur le composant mince par l'autre composant en regard de ce dernier auquel il doit être fixé. Une telle déformation, courbant le composant, provoque généralement :
- soit des erreurs d'alignement des billes et des plots correspondants, susceptibles de fragiliser leur assemblage en dégradant la soudure, voire même en l'empêchant (la bille et le plot correspondant n'ayant aucun contact lors de l'hybridation) ;
- soit une détérioration irréversible du composant.

Bien qu'une réduction de l'intensité de la dépression soit envisageable (par exemple en diminuant le débit d'aspiration des moyens d'aspiration), celle-ci est, en pratique, difficilement réalisable car elle entraîne une diminution de la force de maintien du composant mince sur le support, et donc un affaiblissement du maintien, ce qui n'est pas souhaitable.

Aussi, pour pallier une telle déformation d'un composant mince, il est connu de réduire la largeur des rainures d'aspiration d'air pour atteindre une largeur inférieure à 0,5 mm.

Cependant, il est actuellement techniquement difficile de réaliser des canaux d'aspiration de diamètre inférieur à 0,5 mm dans des matériaux durs du type de celui formant le plateau de réception des supports. En outre, le débit d'aspiration en air par les canaux d'aspiration d'air dépendant de leur diamètre, une réduction de ce dernier pour l'amener à une valeur inférieure à 0,5 mm abaisse la force de maintien par dépression de façon indésirable.

La solution actuellement retenue consiste donc à réaliser des rainures d'aspiration de largeur réduite (inférieure à 0,5 mm) traversées depuis leur fond jusqu'à leur surface d'aspiration, dans une direction associée à leur profondeur, par des canaux d'aspiration correspondants qui débouchent dans la face plate de réception du support. Les canaux d'aspiration forment des empreintes à la manière de gouttière dans les parois longitudinales des rainures. Il en résulte une déformation des orifices d'aspiration par lesquels débouchent les rainures au niveau de la face plate de réception. Aussi, lorsque le composant est mince, il se produit une déformation locale de celui-ci au niveau des empreintes de chacun des canaux d'aspiration entraînant les inconvénients mentionnés ci-dessus, à savoir une fragilisation des soudures, une absence de soudure, une casse du composant.

La présente invention a pour objet de remédier à ces inconvénients et, notamment, de fournir un support à dépression d'air capable de recevoir des composants de faible épaisseur sans les déformer ni les détériorer.

A cette fin, selon l'invention, le support à dépression d'air pour composants, destiné à être relié à des moyens d'aspiration d'air, ledit support étant formé d'un plateau de réception comprenant :
- une face plate de réception ;
- au moins une rainure d'aspiration ménagée dans ladite face plate de réception et sur laquelle peut être disposé et maintenu un composant ; et
- au moins un canal d'aspiration pratiqué dans l'épaisseur dudit plateau et apte à être relié, par une de ses deux extrémités, auxdits moyens d'aspiration,
est remarquable :
- en ce que ladite rainure forme une chambre d'aspiration oblongue à parois longitudinales lisses qui débouche dans la face plate de réception par un orifice d'aspiration oblong à bords longitudinaux rectilignes ;
- en ce que ledit canal d'aspiration s'arrête, par son autre extrémité, dans le fond de ladite rainure, de manière à pouvoir mettre en communication la chambre d'aspiration avec lesdits moyens d'aspiration ; et
- en ce que la largeur de la section transversale dudit canal d'aspiration est supérieure à la largeur dudit orifice d'aspiration oblong.

Ainsi, grâce à l'invention, les parois longitudinales de la ou des rainures d'aspiration ne sont pas déformées par le ou les canaux d'aspiration d'air du plateau, ces derniers s'arrêtant dans le fond de celles-ci sans les traverser. Il est ainsi possible de réaliser des rainures d'aspiration de très faible largeur, par exemple égale à 0,1 mm, qui présentent des orifices de sortie oblongs à bords longitudinaux rectilignes tout en ayant des canaux d'aspiration de diamètre bien supérieur à cette largeur, pour assurer un débit d'aspiration et une force de maintien satisfaisants. La réalisation d'une ou plusieurs rainures d'aspiration non déformées dans la face plate de réception permet au support de réception de recevoir des composants de très faible épaisseur (par exemple inférieure à 50 µm) sans risque de déformation ou de détérioration. La qualité de l'assemblage de composants ensemble est ainsi garantie.

En outre, grâce à l'invention, la taille du ou des canaux d'aspiration peut être ajustée de telle manière que l'on puisse détecter une perte de charge et, par voie de conséquence, l'absence ou la présence d'un composant sur le support.

En outre, ledit canal d'aspiration peut s'étendre longitudinalement selon une direction parallèle à la direction associée à la profondeur de ladite rainure et peut déboucher au centre du fond de cette dernière.

De façon avantageuse, ladite rainure d'aspiration présente une largeur inférieure à 0,5 mm, de préférence égale à 0,1 mm.

Dans une forme de réalisation conforme à l'invention :
- plusieurs rainures d'aspiration, en communication les unes avec les autres, sont ménagées dans la face plate de réception ; et
- plusieurs canaux d'aspiration sont pratiqués dans l'épaisseur dudit plateau et s'arrêtent dans le fond de certaines desdites rainures.

En outre, selon cette forme de réalisation :
- lesdites rainures d'aspiration peuvent comporter :
   ■ des rainures d'aspiration de faible profondeur ; et
   ■ des rainures d'aspiration profondes qui présentent, sur au moins une partie de leur longueur, une profondeur supérieure à celle desdites rainures de faible profondeur ; et
- lesdits canaux d'aspiration peuvent être uniquement en communication avec lesdites rainures profondes.

De plus, dans une variante de réalisation de l'invention, lesdites rainures profondes, agencées au voisinage du centre dudit maillage, peuvent comporter chacune :
- une portion centrale, s'étendant de part et d'autre du centre desdites rainures, dont la profondeur, sensiblement constante, est égale à une première valeur ;
- deux portions d'extrémité, disposées aux extrémités respectives desdites rainures, dont la profondeur, sensiblement constante, est égale à une seconde valeur, inférieure à ladite première valeur de profondeur ; et
- deux portions intermédiaires, reliant la portion centrale aux portions d'extrémité, dont la profondeur varie progressivement depuis la première valeur pour atteindre la seconde valeur.

En outre, lesdites rainures d'aspiration peuvent être régulièrement réparties, au moins sur une partie dudit plateau, pour former un maillage régulier sur la face plate de réception.

Par ailleurs, la présente invention concerne également une machine pour l'assemblage de composants, comprenant un premier et un second supports de composants à dépression d'air, disposés en regard et aptes à être déplacés de façon relative transversalement l'un par rapport à l'autre pour pouvoir se rapprocher et s'éloigner, lesdits premier et second supports portant respectivement au moins un premier composant et au moins un second composant disposés en regard et pouvant être amenés au contact l'un de l'autre par rapprochement desdits premier et second supports, qui est remarquable en ce que lesdits premier et second supports sont du type de celui décrit précédemment.
Les figures du dessin annexé feront bien comprendre comment l'invention peut être réalisée. Sur ces figures, des références identiques désignent des éléments semblables.
La figure 1 représente, dans une vue schématique du dessus, un premier exemple de support de composants à dépression d'air conforme à la présente invention.
La figure 2 est une coupe schématique transversale du support de la figure 1, selon la ligne de coupe II-II.
La figure 3 montre, dans une vue schématique du dessus, un second exemple de support de composants à dépression d'air conforme à la présente invention.
La figure 4 est une coupe schématique transversale agrandie du support de composants de la figure 3, selon la ligne de coupe IV-IV.
La figure 5, semblable à la figure 4, illustre une variante du second exemple de support de composants conforme à la présente invention.

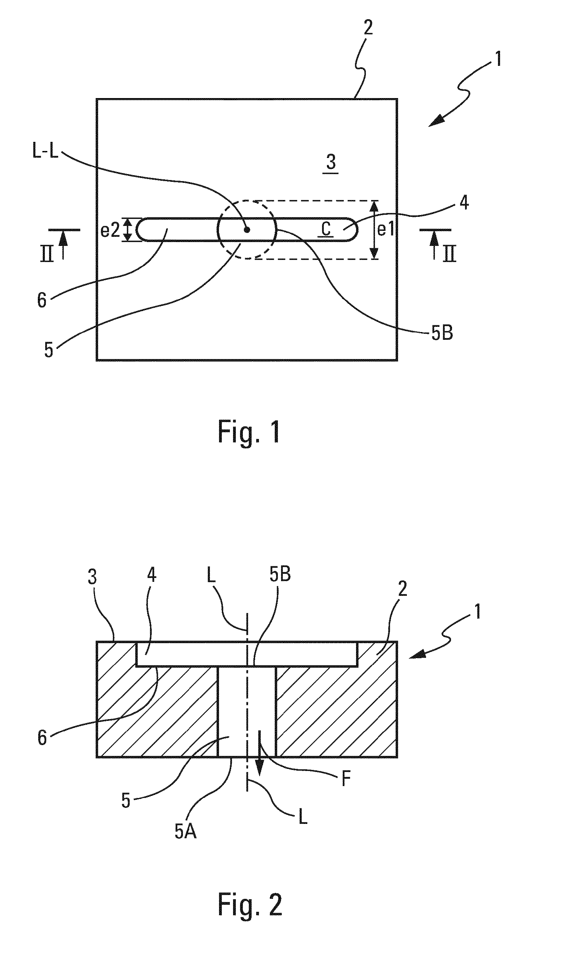

Sur la figure 1, on a représenté un premier exemple de réalisation d'un support 1 à dépression d'air pour composants conforme à la présente invention. Le support 1 est, quoique non exclusivement, particulièrement bien adapté à la réception de composants de faible épaisseur, par exemple inférieure à 50 µm, et de faible largeur.

Le support 1 est formé d'un plateau 2 pour la réception de composants. Un tel plateau 2 est, par exemple, réalisé à partir de carbure de silicium, afin de pouvoir être porté à haute température lors d'une opération d'hybridation sans déformation.

Comme le montrent les figures 1 et 2, le plateau de réception 2 comporte :
- une face plate de réception 3 sur laquelle peut être disposé et maintenu un composant (non représenté) ;
- une rainure d'aspiration 4 ménagée dans la face plate de réception 3. En variante, une pluralité de rainures d'aspiration pourrait être réalisée dans la face plate 3. La rainure d'aspiration 4 forme une chambre d'aspiration C oblongue à parois longitudinales lisses qui débouche dans la face plate 3 par un orifice d'aspiration oblong ; et
- un canal d'aspiration 5 pratiqué dans l'épaisseur du plateau 2 et apte à être relié, par une de ses deux extrémités 5A, à des moyens d'aspiration non représentés sur les figures 1 et 2. Le flux d'air traversant le canal 5 est symbolisé par la flèche F.

Comme l'illustre la figure 2, le canal d'aspiration 5 s'arrête, par son autre extrémité 5B, dans le fond 6 de la rainure 4, au centre de celui-ci, pour mettre en communication la chambre d'aspiration C avec les moyens d'aspiration reliés à l'extrémité 5A du canal 5.

Dans cet exemple, le canal d'aspiration 5 est cylindrique et présente un axe longitudinal L-L. Il s'étend longitudinalement selon une direction parallèle à la direction associée à la profondeur de la rainure 4.

En outre, le diamètre e1 du canal 5 est supérieur à la largeur e2 de la rainure d'aspiration (soit e1 >e2) et donc de l'orifice d'aspiration oblong correspondant. A titre d'exemple illustratif mais non limitatif, la largeur e2 de la rainure d'aspiration 4 est égale à 0,1 mm, alors que le diamètre e1 du canal 5 est égal à 0,5 mm.

Ainsi, du fait que le canal 5 s'arrête dans le fond 6 de la rainure 4, l'orifice d'aspiration oblong de cette dernière n'est pas déformé et présente des bords longitudinaux rectilignes. On peut alors ménager une rainure 4 de très faible largeur, tout en ayant un canal d'aspiration de diamètre très supérieur à cette largeur, pour assurer un débit d'aspiration et une force de maintien satisfaisants.

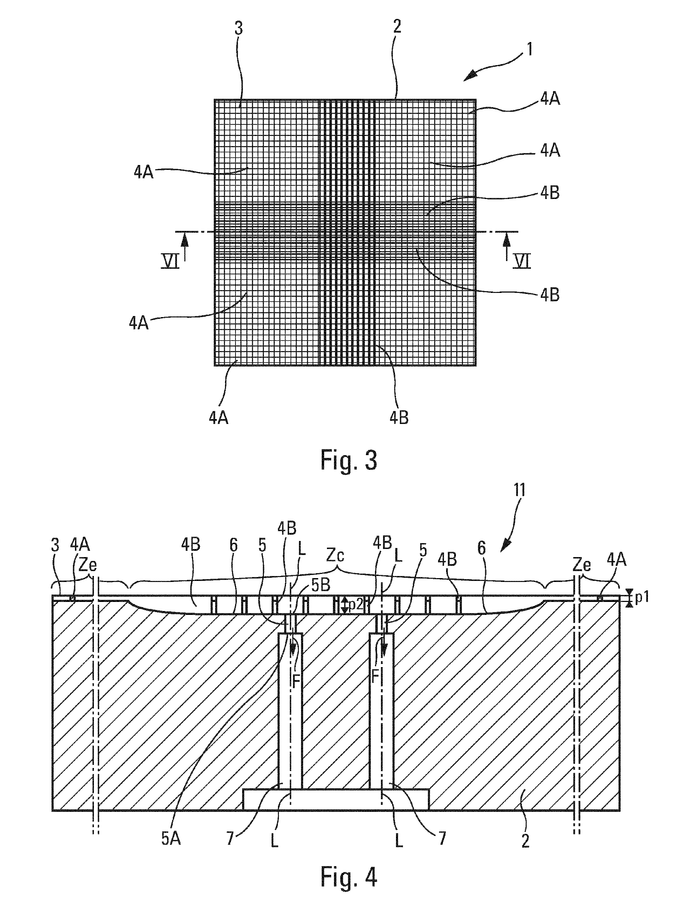

Dans le second exemple de réalisation de l'invention des figures 3 et 4, le support 1 à dépression d'air pour composants comporte une pluralité de rainures d'aspiration rectilignes 4A et 4B qui sont ménagées dans la face plate de réception 3 du plateau 2 carré.

Parmi la pluralité de rainures d'aspiration 4A, 4B communiquant les unes avec les autres, il existe :
- des rainures d'aspiration de faible profondeur 4A égale à p1 ; et
- des rainures d'aspiration profondes 4B dont la profondeur est :
   ■ sur une portion centrale Zc, égale à une valeur p2 qui est supérieure à celle des rainures de faible profondeur 4A (soit p2>p1) ; et
   ■ sur deux portions d'extrémités Ze prolongeant la portion centrale Zc, égale à p1 .

Dans le second exemple, les rainures profondes 4B, en nombre inférieur aux rainures de faible profondeur 4A, sont régulièrement réparties, les unes par rapport aux autres, dans un voisinage du centre du plateau 2 et s'étendent de part et d'autre de celui-ci jusqu'à ses bords latéraux. Ainsi, les portions centrales Zc des rainures profondes 4B définissent un maillage central réduit de forme carrée, par exemple de 20 mm de côté.

Au contraire, les rainures de faible profondeur 4A sont éloignées du centre du plateau 2 et s'étendent sur l'intégralité de la longueur de celui-ci pour déboucher, à chacune de leurs deux extrémités, au niveau des bords latéraux du plateau 2. Les rainures 4A, régulièrement espacées les unes des aux autres, encadrent et traversent ainsi les rainures profondes 4B pour former quatre maillages réguliers aux quatre coins du plateau 2. Bien entendu, tout autre agencement des rainures d'aspiration reste néanmoins envisageable.

Par ailleurs, des canaux d'aspiration 5 cylindriques et d'axe longitudinal L-L sont pratiqués dans l'épaisseur du plateau 2 et s'arrêtent, au niveau d'une de leurs extrémités 5B, dans le fond 6 des rainures profondes 4B. Ainsi, les bords rectilignes des orifices d'aspiration oblongs des rainures profondes 4B ne sont pas déformés.

Comme le montre la figure 4, l'extrémité 5A des canaux 5 est reliée à des moyens d'aspiration 7 qui sont intégrés au plateau 3.

De même que pour le premier exemple, le diamètre des canaux 5 (par exemple égal à 0,5 mm) est supérieur à la largeur des orifices d'aspiration oblongs des rainures profondes 4B (par exemple égale à 0,1 mm).

Il est à noter que la largeur des rainures de faible profondeur 4A peut être identique à celle des rainures profondes 4B. En variante, elle pourrait être différente.

Dans ce second exemple, chaque rainure profonde 4B est reliée à deux canaux 5. Il est évident que les rainures profondes pourraient être reliées chacune à un seul canal d'aspiration, ou bien à plus de deux canaux d'aspiration.

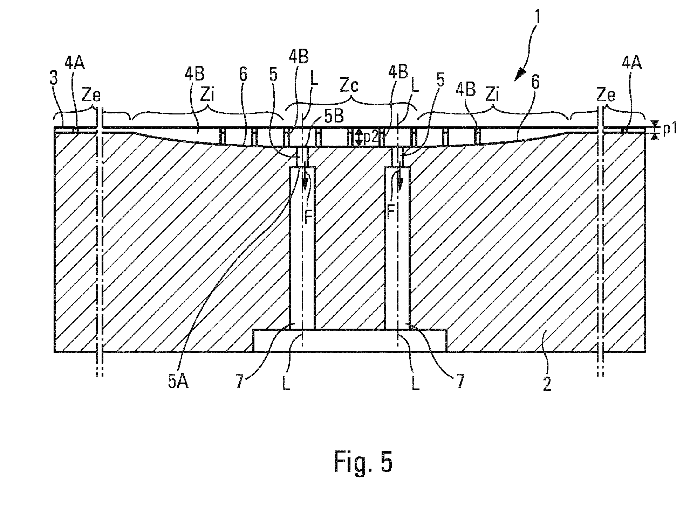

Dans une variante du second exemple illustrée par la figure 5, seules les rainures profondes 4B sont modifiées par rapport à celles de l'exemple des figures 3 et 4.

En particulier, dans cette variante, les rainures 4B comprennent chacune:
- une portion centrale Zc, s'étendant de part et d'autre du centre des rainures 4B, dont la profondeur, sensiblement constante, est égale à une première valeur p2 ;
- deux portions d'extrémité Ze, disposées aux extrémités respectives des rainures 4B, dont la profondeur, sensiblement constante, est égale à une seconde valeur p1, inférieure à p2 (soit p2>p1) ; et
- deux portions intermédiaires Zi, reliant la portion centrale Zc aux portions d'extrémité Ze, dont la profondeur varie progressivement depuis la première valeur p2 pour atteindre la seconde valeur p1 en s'éloignant du centre.

Quel que soit l'exemple de réalisation précité, les supports de composants décrits en référence aux figures 1 à 4 sont destinés à être montés sur une machine dédiée à l'assemblage de composants (non représentée sur les figures).

Une telle machine comprend un premier et un second supports 1 de composants à dépression d'air du type de ceux des figures 1 à 4, disposés en regard et aptes à être déplacés de façon relative transversalement l'un par rapport à l'autre pour pouvoir se rapprocher et s'éloigner.

Les premier et second supports portent respectivement au moins un premier composant (par exemple une puce) et au moins un second composant (par exemple un capteur substrat) disposés en regard et pouvant être amenés au contact l'un de l'autre par rapprochement des premier et second supports 1. Une opération d'hybridation parachève ensuite leur assemblage.

## Revendications

1. Support à dépression d'air pour composants, destiné à être relié à des moyens d'aspiration d'air (7), ledit support (1) étant formé d'un plateau de réception (2) comprenant :
- une face plate de réception (3) ;
- au moins une rainure d'aspiration (4 ; 4A, 4B) ménagée dans ladite face plate de réception et sur laquelle peut être disposé et maintenu un composant ; et
- au moins un canal d'aspiration (5) pratiqué dans l'épaisseur dudit plateau (2) et apte à être relié, par une de ses deux extrémités (5A), auxdits moyens d'aspiration (7),
**caractérisé :**
- **en ce que** ladite rainure (4 ; 4B) forme une chambre d'aspiration (C) oblongue à parois longitudinales lisses qui débouche dans la face plate de réception par un orifice d'aspiration oblong à bords longitudinaux rectilignes ;
- **en ce que** ledit canal d'aspiration (5) s'arrête, par son autre extrémité (5B), dans le fond (6) de ladite rainure (4 ; 4B), de manière à pouvoir mettre en communication la chambre d'aspiration (C) avec lesdits moyens d'aspiration (7) ; et
- **en ce que** la largeur (e1) de la section transversale dudit canal d'aspiration (5) est supérieure à la largeur (e2) dudit orifice d'aspiration oblong.

2. Support de composant selon la revendication 1,
**caractérisé en ce que** ledit canal d'aspiration (5) s'étend longitudinalement selon une direction parallèle à la direction associée à la profondeur de ladite rainure (4 ; 4B).

3. Support de composant selon l'une des revendications 1 ou 2, **caractérisé en ce que** ledit canal d'aspiration (5) débouche au centre du fond (6) de ladite rainure (4 ; 4B).

4. Support de composant selon l'une des revendications 1 à 3, **caractérisé en ce que** ladite rainure d'aspiration (4 ; 4B) présente une largeur inférieure à 0,5 mm, de préférence égale à 0,1 mm.

5. Support de composant selon l'une des revendications 1 à 4, **caractérisé :**
- **en ce que** plusieurs rainures d'aspiration (4A, 4B), en communication les unes avec les autres, sont ménagées dans la face plate de réception (3) ; et
- **en ce que** plusieurs canaux d'aspiration (5) sont pratiqués dans l'épaisseur dudit plateau (2) et s'arrêtent dans le fond (6) de certaines desdites rainures (4B).

6. Support de composant selon la revendication 5,
**caractérisé :**
- **en ce que** lesdites rainures d'aspiration (4A, 4B) comportent :
■ des rainures d'aspiration de faible profondeur (4A) ; et
■ des rainures d'aspiration profondes (4B) qui présentent, sur au moins une partie de leur longueur, une profondeur (p2) supérieure à celle (p1) desdites rainures de faible profondeur (4A) ; et
- **en ce que** lesdits canaux d'aspiration (5) sont uniquement en communication avec lesdites rainures profondes (4B).

7. Support de composant selon la revendication 6,
**caractérisé en ce que** lesdites rainures profondes (4B), agencées au voisinage du centre dudit plateau (2), comportent chacune :
- une portion centrale (Zc), s'étendant de part et d'autre du centre desdites rainures (4B), dont la profondeur (p2), sensiblement constante, est égale à une première valeur ;
- deux portions d'extrémité (Ze), disposées aux extrémités respectives desdites rainures (4B), dont la profondeur (p1), sensiblement constante, est égale à une seconde valeur, inférieure à ladite première valeur de profondeur ; et
- deux portions intermédiaires (Zi), reliant la portion centrale (Zc) aux portions d'extrémité (Ze), dont la profondeur varie progressivement depuis la première valeur (p2) pour atteindre la seconde valeur (p1).

8. Support de composant selon l'une des revendications 5 à 7, **caractérisé en ce que** lesdites rainures d'aspiration (4A, 4B) sont régulièrement réparties, au moins sur une partie dudit plateau (2), pour former un maillage régulier sur la face plate de réception (3).

9. Machine pour l'assemblage de composants, comprenant un premier et un second supports (1) de composants à dépression d'air, disposés en regard et aptes à être déplacés de façon relative transversalement l'un par rapport à l'autre pour pouvoir se rapprocher et s'éloigner, lesdits premier et second supports portant respectivement au moins un premier composant et au moins un second composant disposés en regard et pouvant être amenés au contact l'un de l'autre par rapprochement desdits premier et second supports,
**caractérisée en ce que** lesdits premier et second supports (1) sont du type de celui spécifié sous l'une des revendications 1 à 8.
